(19) Europäisches Patentamt
European Patent Office
Office européen des brevets

(11) **EP 1 327 515 B1**

(12) **EUROPEAN PATENT SPECIFICATION**

(45) Date of publication and mention
of the grant of the patent:
**10.08.2005 Bulletin 2005/32**

(51) Int Cl.⁷: **B32B 15/08**, B32B 5/18,
H01B 3/30

(21) Application number: **03000070.7**

(22) Date of filing: **07.01.2003**

(54) **Polyimide - metal foil wiring boards for high frequency use**

Polyimid-Metallfolie Leiterplatte für Hochfrequenzanwendungen

Polyimide - métal panneau de circuit imprimé pour applications à haute fréquence

(84) Designated Contracting States:
**DE FR GB**

(30) Priority: **10.01.2002 JP 2002003224**

(43) Date of publication of application:
**16.07.2003 Bulletin 2003/29**

(73) Proprietor: **NITTO DENKO CORPORATION**
**Osaka (JP)**

(72) Inventors:
• **Kawashima, Toshiyuki**
**Ibaraki-shi, Osaka (JP)**
• **Tahara, Nobuharu**
**Ibaraki-shi, Osaka (JP)**

• **Ikeda, Kenichi**
**Ibaraki-shi, Osaka (JP)**

(74) Representative: **Grünecker, Kinkeldey,**
**Stockmair & Schwanhäusser Anwaltssozietät**
**Maximilianstrasse 58**
**80538 München (DE)**

(56) References cited:
**EP-A- 1 025 989          FR-A- 2 713 139**
**US-A- 4 751 136**

• **DATABASE WPI Section Ch, Week 198803**
**Derwent Publications Ltd., London, GB; Class**
**A85, AN 1988-017844 XP002234851 & JP 62**
**279936 A (HITACHI CHEM CO LTD), 4 December**
**1987 (1987-12-04)**

**Description**

The present invention relates to a metal foil-based layered product comprising a metal foil and a porous resin layer formed thereon and a process for producing the same. The invention is useful for forming an insulating layer for wiring boards for high-frequency use.

With the recent trend toward higher information processing rates and higher communication wave frequencies in information/communication appliances, the wiring boards on which electronic and other parts are to be mounted are also required to have suitability for high frequencies. For example, the insulating layers in such wiring boards are required to have a low permittivity and a low dielectric dissipation factor at high frequencies so as to attain excellent high frequency transmission characteristics and excellent low crosstalk characteristics.

The reasons for that are as follows. In the circuit of a wiring board, an energy loss in transmission, which is called a transmission loss, occurs. This transmission loss is proportional to the product of the frequency f of the signal, the 1/2 power of the dielectric constant $\varepsilon$, and the dielectric dissipation factor tan $\delta$ of the material. Because of this, materials to be used in wiring boards for higher frequencies f are especially required to have a low dielectric constant $\varepsilon$ and a low dielectric dissipation factor tan $\delta$. Furthermore, materials having a low dielectric constant $\varepsilon$ are desired for high frequency applications also from the standpoint that the rate of signal transmission is inversely proportional to the 1/2 power of dielectric constant $\varepsilon$.

In the method which has been generally employed for forming such an insulating layer having a low permittivity and a low dielectric dissipation factor, a resin material which itself has a low permittivity is used. Known examples of such low permittivity resin materials include fluoropolymers such as polytetrafluoroethylene and polyimide resins.

On the other hand, there is a technique for forming an insulating layer having a lower permittivity than the resin material itself constituting the layer. This technique comprises forming the insulating layer so as to have a porous structure. For example, JP-A-62-279936 proposes a process for producing a metal foil-based layered product for high frequency use which comprises forming a porous precursor layer on a metal foil by a wet film-forming method using a solution containing a poly(amic acid) and then imidizing the polymer to thereby form a porous polyimide layer. This metal foil is processed mainly by wet etching in a later step to form a circuit pattern. Thus, the metal foil is used as a wiring layer.

However, the metal foil-based layered product described above was found to have the following drawback. When the metal foil is processed by wet etching, the etchant infiltrates into those areas of the porous layer which have been exposed by the etching. The etchant which has infiltrated into the porous layer is difficult to effectively remove, and the residual etchant arouses problems such as circuit pattern corrosion, migration (short-circuiting by metal deposition), etc.

JP-A-2000-319442 proposes a process for producing a metal foil-based layered product which comprises forming a porous polyimide layer on a substrate other than metal foils in the same manner as described above and then superposing a metal layer on one or each side of the resulting coated substrate through a heat-resistant adhesive layer. The examples of this heat-resistant adhesive which are specifically disclosed in this publication include films (20 $\mu$m thick) formed from thermosetting resins.

With the technique shown above, the problems caused by etchant infiltration can be avoided. However, the technique is disadvantageous from the standpoint of production steps because it necessitates the steps of forming the porous layer using another substrate, stripping off this substrate, superposing a metal foil, and forming and curing an adhesive layer. Furthermore, the thickness of the adhesive layer should be larger in some degree so as to obtain sufficient adhesive force between the adhesive layer and the porous layer. Moreover, the adhesive can infiltrate into pores of the porous layer during bonding. In either case, there is a problem that the effect of obtaining an insulating layer having a reduced permittivity is decreased.

US-A-4751136 relates to a substrate for high-frequency circuits, comprising a porous insulator layer and a metal foil laminated over at least one side of the insulator layer through a water-impermeable film. The porous insulator layer may be formed of a polyimide and the water-impermeable film may be formed of a plastic or a plastic adhesives.

The object of the present invention is to provide a metal foil-based layered product which can eliminate the problems caused by etchant infiltration, can be produced easily, and is sufficiently effective in reducing the permittivity of the whole insulating layer, and to provide a process for producing the layered product.

As a result of intensive investigation on production processes for reducing the thickness of a film to be interposed between a metal foil and a porous layer in order to accomplish this object, it has been found that this object can be accomplished by forming a porous precursor layer by a wet coagulation method on an undercoat film layer which has been imidized at least partly and then conducting imidization.

The invention provides a metal foil-based layered product comprising a metal foil and a porous resin layer formed on the metal foil through a resin film layer, the resin film layer having a thickness of from 0.1 to 15 $\mu$m, wherein the resin film layer and the porous resin layer each comprise a polyimide resin.

The resin film layer preferably does not substantially penetrate into the pores of the porous resin layer.

The present invention further provides a process for producing a metal foil-based layered product which comprises the steps of: forming on a metal foil an undercoat film layer comprising a poly(amic acid) which has been imidized at least partly; forming a porous precursor layer on the undercoat film layer by a wet film-forming method using a solution containing a poly(amic acid); and imidizing at least the porous precursor layer.

In this process, the step of forming the undercoat film layer preferably comprises applying a solution containing a poly(amic acid) to the metal foil and then subjecting the resulting coating to drying and imidization.

The undercoat film layer preferably has a thickness of from 0.1 to 15 $\mu$m.

The metal foil-based layered product of the invention has the following advantages. Since the layered product comprises a metal foil and a porous resin layer formed thereon through a resin film layer, the porous resin layer is prevented from being exposed when the metal foil is processed by wet etching. Consequently, the etchant does not infiltrate into pores of the layer and, hence, the problems caused by a residual etchant can be eliminated. Furthermore, since the resin film layer can be formed in a thickness of from 0.1 to 15 $\mu$m, the effect of reducing the permittivity of the whole insulating layer can be sufficiently obtained.

Moreover, since the resin film layer and the porous resin layer each comprise a polyimide resin, this layered product can be easily produced by the process of the invention without using an adhesive. In addition, this layered product has sufficiently high adhesive force between the resin film layer and the porous resin layer.

In the case where the resin film layer does not substantially penetrate into the pores of the porous resin layer, this layered product produces an enhanced permittivity-reducing effect as compared with the structure in which an adhesive has penetrated into pores of the porous resin layer.

On the other hand, the production process of the invention has the following advantages. Since a solution containing a poly(amic acid) is applied to an undercoat film layer which has been imidized at least partly, the undercoat film layer is more apt to retain its shape as compared with the case in which the solution is applied to an undercoat film layer which has undergone drying only. Consequently, the resin film layer formed from this undercoat resin layer not only has high etchant barrier properties but also can have a reduced thickness. Especially when a porous precursor layer is formed on the undercoat film layer in which imidization has not been completed, then the adhesive force between the resin film layer and porous resin layer obtained can be further increased.

When the step of forming the undercoat film layer comprises applying a solution containing a poly(amic acid) to a metal foil and then subjecting the resulting coating to drying and imidization, then there is no need of conducting a step in which an undercoat film layer separately formed is laminated to a metal foil. Namely, the production steps can be more simplified.

In the case where the undercoat film layer has a thickness of from 0.1 to 15 $\mu$m, not only etchant barrier properties can be obtained with higher certainty but also the effect of reducing the permittivity of the whole insulating layer is sufficient.

Embodiments of the invention will be explained below. First, the process of the invention is explained.

The process of the invention includes the step of forming on a metal foil an undercoat film layer comprising a poly(amic acid) which has been imidized at least partly. This step may be conducted by separately forming an undercoat film layer on another coating substrate or the like and laminating (transferring) this film layer to a metal foil. It is, however, preferred to apply a solution containing a poly(amic acid) to a metal foil and then subjecting the resulting coating to drying and imidization to thereby form an undercoat film layer which has been imidized at least partly.

Examples of the metal foil that can be used are any of various foils made of copper, cupro-nickel, bronze, brass, aluminum, nickel, iron, stainless steel, gold, silver, platinum, and the like. The thickness of the metal foil is preferably from 1 to 50 $\mu$m. In the invention, it is especially preferred to use a copper foil, which is suitable for forming the wiring patterns of wiring boards. The surface of the metal foil may be subjected to various physical or chemical surface treatments, such as a surface-roughening treatment and a blackening treatment, for the purpose of enhancing adhesion to the resin film layer.

The application of a poly(amic acid) in a solution state has an advantage that poly(amic acid)s are less limited in molecular structure than polyimides due to their high solubility. Because of this, the following compounds can be used as the acid component and amine component for constituting the poly(amic acid). For thermal imidization, acid components in the form of a carboxylic acid may be used.

Examples of the acid component include tetracarboxylic dianhydrides such as pyromellitic dianhydride, 3,3',4,4'-benzophenonetetracarboxylic dianhydride, 3,3',4,4'-biphenyltetracarboxylic dianhydride, 2,3,3',4-biphenyltetracarboxylic dianhydride, 2,3,6,7-naphthalenetetracarboxylic dianhydride, 1,2,5,6-naphthalenetetracarboxylic dianhydride, 1,4,5,8-naphthalenetetracarboxylic dianhydride, 2,2'-bis(3,4-dicarboxyphenyl)propane dianhydride, bis(3,4-dicarboxyphenyl) sulfone dianhydride, perylene-3,4,9,10-tetracarboxylic dianhydride, bis(3,4-dicarboxyphenyl) ether dianhydride, ethylenetetracarboxylic dianhydride, and butanetetracarboxylic dianhydride.

On the other hand, examples of the diamine component include 4,4'-diaminodiphenyl ether (DDE), 4,4'-diaminodiphenylmethane, 3,3'-diaminodiphenylmethane, 3,3'-dichlorobenzidine, 4,4'-diaminodiphenyl sulfide, 3,3'-diaminodiphenyl sulfone, 1,5-diaminonaphthalene, m-phenylenediamine, p-phenylenediamine (PDA), 3,3'-dimethyl-4,4'-biphenyldiamine, benzidine, 3,3'-dimethylbenzidine, 3,3'-dimethoxybenzidine, 4,4'-diaminodiphenyl sulfone, 4,4'-diaminodiphenyl sulfide, 4,4'-diaminodiphenylpropane, 2,4-bis(β-amino-t-butyl)toluene, bis(p-β-amino-t-butylphenyl) ether, bis(p-β-methyl-δ-aminophenyl)benzene, bis-p-(1,1-dimethyl-5-aminopentyl)benzene, 1-isopropyl-2,4-m-phenylenediamine, m-xylylenediamine, p-xylylenediamine, di(p-aminocyclohexyl)methane, hexamethylenediamine, heptamethylenediamine, octamethylenediamine, nonamethylenediamine, decamethylenediamine, diaminopropyltetramethylene, 3-methylheptamethylenediamine, 4,4-dimethylheptamethylenediamine, 2,11-diaminododecane, 1,2-bis-3-aminopropoxyethane, 2,2-dimethylpropylenediamine, 3-methoxyhexamethylenediamine, 2,5-dimethylhexamethylenediamine, 2,5-dimethylheptamethylenediamaine, 2,5-dimethylheptamethylenediamine, 3-methylheptamethylenediamine, 5-methylnonamethylenediamine, 2,11-diaminododecane, 2,17-diaminoeicosadecane, 1,4-diaminocyclohexane, 1,10-diamino-1,10-dimethyldecane, 1,12-diaminooctadecane, 2,2-bis[4-(4-aminophenoxy)phenyl]propane, piperazine, $H_2N(CH_2)_3O(CH_2)_2O(CH_2)NH_2$, $H_2N(CH_2)_3S(CH_2)_3NH_2$, and $H_2N(CH_2)_3N(CH_3)_2(CH_2)_3NH_2$.

A poly(amic acid) obtained beforehand by polymerizing the acid component and the amine component may be dissolved in a solvent to prepare a film-forming solution. Alternatively, a solution obtained by solution-polymerizing the two components may be used as a film-forming solution after additives are added thereto. This solution polymerization is preferably conducted while keeping the water content in the system on the lowest possible level.

The poly(amic acid) is not particularly limited as long as it mainly comprises repeating units comprising a residue of an acid component, such as those enumerated above, and a residue of an amine component, such as those enumerated above, bonded to each other through an amide linkage. The poly(amic acid) may contain units derived from one or more other comonomers or contain a blending component. The poly(amic acid) in the film-forming solution may be partly imidized in such a degree that this imidization does not impair the solubility of the polymer. From the standpoint of imparting heat resistance, a low coefficient of linear thermal expansion, and a low coefficient of moisture absorption to the polyimide to be obtained, poly(amic acid)s having aromatic groups in the main chain are preferable. Examples thereof include poly(amic acid)s comprising a polymerized product of an aromatic tetracarboxylic acid component and an aromatic diamine component.

Poly(amic acid)s obtained from BPDA (biphenyltetracarboxylic dianhydride), DDE (diaminodiphenyl ether), and PPD (p-phenylenediamine) are preferably used from the standpoints of the solubility thereof, and the heat resistance, coefficient of linear thermal expansion and other properties of the polyimide to be obtained therefrom. In these poly(amic acid)s, the PPD/DDE molar ratio is preferably from 50/50 to 99/1, more preferably from 70/30 to 95/5.

Solvents for the poly(amic acid) are not particularly limited as long as the polymer is soluble therein. However, aprotic polar solvents such as N-methyl-2-pyrrolidone, N,N-dimethylacetamide, N,N-dimethylformamide, and dimethyl sulfoxide are preferred from the standpoints of solubility and the rate of solvent displacement by a coagulating solvent. Preferred examples thereof include N-methyl-2-pyrrolidone. A solvent such as diethylene glycol dimethyl ether, diethylene glycol diethyl ether, diethylene glycol dibutyl ether, triethylene glycol diethyl ether, 1,2-dimethoxyethane, 1,2-diethoxyethane, or 1,2-dibutoxyethane may be mixed with the solvent for the poly(amic acid) to thereby regulate the rate of solvent displacement.

For applying the solution containing a poly(amic acid) to a metal foil, any of various coaters such as a film applicator can be used. The poly(amic acid) concentration in the solution is preferably from 5 to 25% by weight, more preferably from 7 to 20% by weight, when the viscosity during application, ease of drying, etc., are taken into account.

The drying and imidization of the solution applied may be conducted simultaneously or successively. It is, however, preferred to first conduct drying at a temperature not higher than the boiling point of the solvent and then conduct imidization at a temperature of from 200 to 500°C, preferably from 250 to 450°C. In case where imidization is conducted at too high temperature, the polymer disadvantageously is completely or nearly completely imidized. Consequently, that temperature range is preferred from the standpoint of further enhancing the adhesive force between the resin film layer and porous resin layer to be obtained, as stated above. The imidization time may be about from 10 to 300 minutes although it varies depending on the temperature. The drying may be conducted, for example, to such a degree that the coating becomes non-flowable.

By the method described above, an undercoat film layer comprising a poly(amic acid) which has been imidized at least partly can be formed on a metal foil. The thickness of the undercoat film layer formed is preferably from 0.1 to 15 μm, more preferably from 0.2 to 8 μm, most preferably from 0.5 to 5 μm, for the reasons described above.

The process of the invention includes the step of forming a porous precursor layer on the undercoat film layer by a wet film-forming method using a solution containing a poly(amic acid). The solution used may be the same as or different from the solution used for forming the undercoat film layer. Examples of the poly(amic acid) and solvent used include the same poly(amic acid)s and solvents enumerated above. In particular, it is preferred to use the same kind of poly(amic acid) so as to increase the adhesive force between the resin film layer and porous resin layer obtained.

When the decrease in molecular weight which can occur during a cleaning step, etc., is taken into account, the weight-average molecular weight, as determined by GPC, of the poly(amic acid) used for the wet film formation is preferably 8,000 or higher, more preferably 10,000 or higher. The upper limit of the weight-average molecular weight thereof is preferably 60,000 from the standpoints of preventing the film-forming solution from having impaired applicability due to a viscosity increase and of the polymer concentration of the varnish.

In the wet film-forming method, a porous layer is generally obtained by dissolving the resin, additives, etc., in a solvent to prepare a film-forming solution (dope), applying (casting) this solution on a substrate (the undercoat film layer in the invention), immersing the coated substrate in a coagulating liquid to cause solvent displacement and thereby coagulate the resin (gelation), removing the solvent and other components by rinsing in water, etc., and then removing the coagulating liquid and other components by drying.

The dope in the invention is applied preferably at a temperature in the range of from -20 to 80°C. The coagulating liquid is not particularly limited as long as it is a liquid in which the poly(amic acid) used is insoluble and which is compatible with the solvent. Examples of the liquid used include water, alcohols such as methanol, ethanol, or isopropyl alcohol, and a mixture of two or more thereof. Water is especially preferred. Although the temperature of the coagulating liquid is not particularly limited, it is preferably from 0 to 80°C.

The poly(amic acid) concentration of the film-forming solution is preferably in the range of from 5 to 25% by weight, more preferably from 7 to 20% by weight. In case where the concentration thereof is too high, the solution has too high viscosity and is difficult to handle. On the other hand, too low concentrations thereof tend to result in difficulties in forming a porous layer.

An inorganic material such as lithium nitrate or an organic material such as polyvinylpyrrolidone may be added for the purpose of controlling pore shape or pore diameter. The concentration of such an additive in the solution is preferably from 1 to 10% by weight. The addition of lithium nitrate increases the rate of displacement of the solvent by a coagulating liquid, whereby a spongy structure having finger void structures (finger-shaped voids) formed therein can be formed. When an additive which reduces the rate of coagulation, such as polyvinylpyrrolidone, is added, a porous layer of a uniform spongy structure can be obtained.

In the invention, the solution applied may be moistened to cause it to wholly or partly coagulate, before being immersed in a coagulating liquid. Thus, by gradually humidifying the solution through a gas phase to coagulate it, it is possible to obtain a porous layer which has an increased porosity around the surface or has an increased average pore diameter in the surface. For controlling the rate of coagulation, the method using a solvent displacement rate regulator as described in JP-A-2000-319442 can be employed.

The moistening may be accomplished by, for example, contacting the film-forming solution with an atmosphere having a relative humidity of from 70 to 100% and a temperature of from 25 to 45°C for from 20 seconds to 2 minutes.

The thickness in which the film-forming solution is applied is not particularly limited. However, too large film thicknesses pose problems, for example, that solvent removal takes much time. In addition, insulating layers for recent multilayered wiring boards are desired to be thin and lightweight and have mechanical strength. Because of these, the thickness of the porous layer constituting an insulating layer is desirably from 2 to 150 μm, preferably from 5 to 90 μm. In the invention, the proportion of the thickness of the resin film layer obtained to that of the porous resin layer obtained (resin film layer/porous resin layer) is preferably from 1 to 50%, more preferably from 5 to 10%, especially from the standpoint of enhancing the effect of reducing the permittivity of the whole insulating layer.

After rinsing in water, the resulting porous layer is taken out and is then dried according to need. The temperature for this drying is not particularly limited as long as pores of the porous layer do not clog. However, drying at 200°C or lower is desirable from the standpoint of handling. The imidization, which will be described below, may be conducted subsequently to or simultaneously with the drying.

The process of the invention includes the step of imidizing at least the porous precursor layer. In the case where the undercoat film layer has been imidized partly, both the undercoat film layer and the porous precursor layer are simultaneously imidized in this step.

The imidization in the invention can be conducted under the same conditions as in the conventional imidization processes. For example, the imidization can be accomplished by holding the coated metal foil in a heating apparatus at a temperature of from 200 to 500°C for from 10 to 300 minutes. It is preferred to use a circulating hot nitrogen atmosphere from the standpoint of efficiently removing the water resulted from ring closure.

The porous layer thus obtained preferably has an average pore diameter regarding pores present in the surface of from 0.01 to 2 μm, an average pore diameter regarding pores present in a section thereof of from 0.2 to 20 μm, and a porosity of from 10 to 80%. The porosity of the whole insulating layer is preferably from 15 to 70%, more preferably from 20 to 60%, from the standpoint of reconciling the effect of reducing the permittivity of the whole insulating layer with mechanical strength.

On the other hand, the metal foil-based layered product of the invention comprises a metal foil and a porous resin layer formed on the metal foil through a resin film layer, wherein the resin film layer has a thickness of from 0.1 to 15 μm. The thickness of the resin film layer is preferably from 0.5 to 5 μm. Although this metal foil-based layered product can be advantageously produced by the process of the invention, it may be obtained by another process.

For example, the metal foil-based layered product is not limited to one in which the resin film layer and porous resin layer each are made of a polyimide resin, and at least either may be made of a heat-resistant resin such as an aramid resin or a poly(phenylene ether) resin (PPE). In this case also, the problems caused by etchant infiltration can be prevented and the effect of reducing the permittivity of the whole insulating layer can be sufficiently obtained.

The metal foil-based layered product preferably has such a structure that the resin film layer has not substantially penetrated into the pores of the porous resin layer. In this case, it is preferred to select a combination of resins showing high adhesion to each other, for example, after wet film formation, because it is necessary to obtain a sufficient adhesive force between the two layers without the aid of an anchoring effect.

It is preferred that the metal foil-based layered product of the invention be used as it is in forming an insulating layer of a wiring board. However, the metal foil-based layered product may be used in wiring board production in the form of a metal foil-clad prepreg impregnated with a semi-cured thermosetting resin. A wiring pattern can be formed on the metal foil of the metal foil-based layered product in an ordinary manner to thereby produce a wiring board.

The prepreg described above contains a semi-cured thermosetting resin infiltrated into pores of the porous resin layer of the metal foil-based layered product of the invention. Examples of the thermosetting resin include epoxy resins, phenolic resins, polyimide resins, and poly(amic acid)s. From the standpoints of cost and handleability, however, epoxy resins are preferred. The semi-cured thermosetting resin may contain catalysts, hardeners, flame retardants, fillers, plasticizers, accelerators, etc.

Examples of techniques for infiltrating a resin into the pores to obtain a prepreg include a method which comprises infiltrating a solvent solution of the resin into the porous layer and then subjecting this porous layer to a drying step (e.g., at 120 to 170°C) to thereby react the resin to some degree while removing the solvent. The prepreg thus obtained, in which the resin is in a semi-cured state, is a sheet reduced in tackiness. By hot-pressing this prepreg, an insulating layer can be formed.

Examples for specifically illustrating the constitutions and advantages of the invention will be explained below together with Comparative Examples. The permittivity and porosity of each metal foil-based layered product were determined in the following manners.

(1) Dielectric Characteristics

The porous layer or film layer-bearing porous layer from which the copper foil had been removed by etching was used as a sample to be examined. A resonator manufactured by Kanto Electronics Corp. was connected to a network analyzer manufactured by Agilent Technologies Inc. to determine the permittivity (strictly speaking, dielectric constant) at 10 GHz.

(2) Porosity

The porosity of the porous layer or film layer-bearing porous layer was calculated from the area $S$ ($cm^2$), thickness $t$ (cm), and weight $m$ (g) thereof and from the density $d$ ($g/cm^3$) of the material constituting the layer, using the following equation.

$$\text{Porosity (\%)} = (1-(m/d)/(Sxt)) \times 100$$

**EXAMPLE 1**

A 15% by weight N-methyl-2-pyrrolidone (NMP) solution of a polyimide precursor obtained from BPDA (biphenyltetracarboxylic dianhydride), DDE (diaminodiphenyl ether), and PPD (p-phenylenediamine) (PPD/DDE molar ratio: 85/15) was used as a film-forming dope. This dope was applied in a uniform thickness to the blackened side of a 1 ounce rolled copper foil with a film applicator having a gap of 15 μm. Immediately thereafter, the coated copper foil was placed in a 100°C drying oven for 15 minutes or more to dry the coating with air circulation. After the drying, the coating was heat-treated at 250°C for 30 minutes in a nitrogen atmosphere to cause the polyimide precursor to undergo thermal ring closure.

After the coating had been cured and then cooled to ordinary temperature, a film-forming dope consisting of the same components as the dope used above and having a solid concentration of 19% by weight was applied in a uniform thickness to the dried polyimide precursor film with a film applicator having a gap of 65 μm. Immediately after the application, this coated copper foil was immersed in 25°C pure water to coagulate the polyimide precursor and then dried at 90°C for 1 hour or more.

The coating thus dried was then heat-treated at 400°C for 3 hours in a nitrogen atmosphere to cause the polyimide precursor to undergo thermal ring closure. Thus, a porous polyimide layer having a film layer was obtained. This porous layer was a uniform spongy layer. The copper foil-clad layered polyimide product obtained had a film layer thickness of 3 μm, porous layer thickness of 22 μm, porosity of 40%, and permittivity of 2.4.

## EXAMPLE 2

The same 15% by weight polyimide precursor solution as in Example 1 was used as a film-forming dope. This dope was applied in a uniform thickness to the blackened side of a 1 ounce rolled copper foil with a film applicator having a gap of 35 $\mu$m. Immediately thereafter, the coated copper foil was placed in a 100°C drying oven for 15 minutes or more to dry the coating with air circulation. After the drying, the coating was heat-treated at 250°C for 30 minutes in a nitrogen atmosphere to cause the polyimide precursor to undergo thermal ring closure.

After the coating had been cured and then cooled to ordinary temperature, a film-forming dope consisting of the same components as the dope used above and having a solid concentration of 19% by weight was applied in a uniform thickness to the dried polyimide precursor film with a film applicator having a gap of 60 $\mu$m. Immediately after the application, this coated copper foil was immersed in 25°C pure water to coagulate the polyimide precursor and then dried at 90°C for 1 hour or more.

The coating thus dried was then heat-treated at 400°C for 3 hours in a nitrogen atmosphere to cause the polyimide precursor to undergo thermal ring closure. Thus, a porous polyimide layer having a film layer was obtained. This porous layer was a uniform spongy layer. The copper foil-clad layered polyimide product obtained had a film layer thickness of 5 $\mu$m, porous layer thickness of 20 $\mu$m, porosity of 36%, and permittivity of 2.5.

## EXAMPLE 3

The same 15% by weight polyimide precursor solution as in Example 1 was used as a film-forming dope. This dope was applied in a uniform thickness to the blackened side of a 1 ounce rolled copper foil with a film applicator having a gap of 70 $\mu$m. Immediately thereafter, the coated copper foil was placed in a 100°C drying oven for 15 minutes or more to dry the coating with air circulation. After the drying, the coating was heat-treated at 250°C for 30 minutes in a nitrogen atmosphere to cause the polyimide precursor to undergo thermal ring closure.

After the coating had been cured and then cooled to ordinary temperature, a film-forming dope consisting of the same components as the dope used above and having a solid concentration of 19% by weight was applied in a uniform thickness to the dried polyimide precursor film with a film applicator having a gap of 45 $\mu$m. Immediately after the application, this coated copper foil was immersed in 25°C pure water to coagulate the polyimide precursor and then dried at 90°C for 1 hour or more.

The coating thus dried was then heat-treated at 400°C for 3 hours in a nitrogen atmosphere to cause the polyimide precursor to undergo thermal ring closure. Thus, a porous polyimide layer having a film layer was obtained. This porous layer was a uniform spongy layer. The copper foil-clad layered polyimide product obtained had a film layer thickness of 10 $\mu$m, porous layer thickness of 15 $\mu$m, porosity of 27%, and permittivity of 2.8.

## COMPARATIVE EXAMPLE 1

The same 15% by weight polyimide precursor solution as in Example 1 was used as a film-forming dope. This dope was applied in a uniform thickness to the blackened side of a 1 ounce rolled copper foil with a film applicator having a gap of 15 $\mu$m. Immediately thereafter, the coated copper foil was placed in a 100°C drying oven for 15 minutes or more to dry the coating with air circulation.

After the coating had been dried and then cooled to ordinary temperature, a film-forming dope consisting of the same components as the dope used above and having a solid concentration of 19% by weight was applied in a uniform thickness to the dried polyimide precursor film with a film applicator having a gap of 65 $\mu$m. Immediately after the application, this coated copper foil was immersed in 25°C pure water to coagulate the polyimide precursor and then dried at 90°C for 1 hour or more.

The coating thus dried was then heat-treated at 400°C for 3 hours in a nitrogen atmosphere to cause the polyimide precursor to undergo thermal ring closure. Thus, a porous polyimide layer having a film layer was obtained. This porous layer was a uniform spongy layer. The copper foil-clad layered polyimide product obtained was examined with an SEM (electron microscope). As a result, no clear boundary was observed between the film layer and the spongy porous layer. The layered polyimide product had a total thickness of about 26 $\mu$m, porosity of 45%, and permittivity of 2.2.

## COMPARATIVE EXAMPLE 2

The same 15% by weight polyimide precursor solution as in Example 1 was used as a film-forming dope. This dope was applied in a uniform thickness to the blackened side of a 1 ounce rolled copper foil with a film applicator having a gap of 35 $\mu$m. Immediately thereafter, the coated copper foil was placed in a 100°C drying oven for 15 minutes or more to dry the coating with air circulation.

After the coating had been dried and then cooled to ordinary temperature, a film-forming dope consisting of the same components as the dope used above and having a solid concentration of 19% by weight was applied in a uniform thickness to the dried polyimide precursor film with a film applicator having a gap of 60 μm. Immediately after the application, this coated copper foil was immersed in 25°C pure water to coagulate the polyimide precursor and then dried at 90°C for 1 hour or more.

The coating thus dried was then heat-treated at 400°C for 3 hours in a nitrogen atmosphere to cause the polyimide precursor to undergo thermal ring closure. Thus, a porous polyimide layer having a film layer was obtained. This porous layer was a uniform spongy layer. The copper foil-clad layered polyimide product obtained was examined with an SEM (electron microscope). As a result, no clear boundary was observed between the film layer and the spongy porous layer. The layered polyimide product had a total thickness of about 30 μm, porosity of 44%, and permittivity of 2.2.

## COMPARATIVE EXAMPLE 3

The same 15% by weight polyimide precursor solution as in Example 1 was used as a film-forming dope. This dope was applied in a uniform thickness to the blackened side of a 1 ounce rolled copper foil with a film applicator having a gap of 70 μm. Immediately thereafter, the coated copper foil was placed in a 100°C drying oven for 15 minutes or more to dry the coating with air circulation.

After the coating had been dried and then cooled to ordinary temperature, a film-forming dope consisting of the same components as the dope used above and having a solid concentration of 19% by weight was applied in an even thickness to the dried polyimide precursor film with a film applicator having a gap of 45 μm. Immediately after the application, this coated copper foil was immersed in 25°C pure water to coagulate the polyimide precursor and then dried at 90°C for 1 hour or more.

The coating thus dried was then heat-treated at 400°C for 3 hours in a nitrogen atmosphere to cause the polyimide precursor to undergo thermal ring closure. Thus, a porous polyimide layer having a film layer was obtained. This porous layer was a uniform spongy layer. The copper foil-clad layered polyimide product obtained was examined with an SEM (electron microscope). As a result, no clear boundary was observed between the film layer and the spongy porous layer. The layered polyimide product had a total thickness of about 33 μm, porosity of 42%, and permittivity of 2.3.

## COMPARATIVE EXAMPLE 4

The same 15% by weight polyimide precursor solution as in Example 1 was used as a film-forming dope. This dope was applied in a uniform thickness to the blackened side of a 1 ounce rolled copper foil with a film applicator having a gap of 130 μm. Immediately thereafter, the coated copper foil was placed in a 100°C drying oven for 15 minutes or more to dry the coating with air circulation.

After the coating had been dried and then cooled to ordinary temperature, a film-forming dope consisting of the same components as the dope used above and having a solid concentration of 19% by weight was applied in a uniform thickness to the dried polyimide precursor film with a film applicator having a gap of 15 μm. Immediately after the application, this coated copper foil was immersed in 25°C pure water to coagulate the polyimide precursor and then dried at 90°C for 1 hour or more.

The coating thus dried was then heat-treated at 400°C for 3 hours in a nitrogen atmosphere to cause the polyimide precursor to undergo thermal ring closure. Thus, a porous polyimide layer having a film layer was obtained. This porous layer was a uniform spongy layer. The copper foil-clad layered polyimide product obtained was examined with an SEM (electron microscope). As a result, the boundary between the film layer and the spongy porous layer was unclear. The layered polyimide product had a total thickness of about 34 μm, porosity of 33%, and permittivity of 2.6.

## COMPARATIVE EXAMPLE 5

The same 19% by weight, on a solid basis, polyimide precursor solution as in Example 1 was applied as a film-forming dope in a uniform thickness to the same copper foil with a film application having a gap of 75 μm. Immediately after the application, the coated copper foil was immersed in 25°C pure water to coagulate the polyimide precursor and then dried at 90°C for 1 hour or more.

The coating thus dried was then heat-treated at 400°C for 3 hours in a nitrogen atmosphere to cause the polyimide precursor to undergo thermal ring closure. Thus, a porous polyimide layer was obtained. This porous layer was a uniform spongy layer.

In the copper foil-clad polyimide layer obtained, the polyimide layer had a total thickness of about 25 μm, porosity of 45%, and permittivity of 2.2.

**COMPARATIVE EXAMPLE 6**

The same 15% by weight polyimide precursor solution as in Example 1 was used as a film-forming dope. This dope was applied in a uniform thickness to the blackened side of a 1 ounce rolled copper foil with a film applicator having a gap of 130 µm. Immediately thereafter, the coated copper foil was placed in a 100°C drying oven for 15 minutes or more to dry the coating with air circulation. After the drying, the coating was heat-treated at 250°C for 30 minutes in a nitrogen atmosphere to cause the polyimide precursor to undergo thermal ring closure.

After the coating had been cured and then cooled to ordinary temperature, a film-forming dope consisting of the same components as the dope used above and having a solid concentration of 19% by weight was applied in a uniform thickness to the dried polyimide precursor film with a film applicator having a gap of 15 µm. Immediately after the application, this coated copper foil was immersed in 25°C pure water to coagulate the polyimide precursor and then dried at 90°C for 1 hour or more.

The coating thus dried was then heat-treated at 400°C for 3 hours in a nitrogen atmosphere to cause the polyimide precursor to undergo thermal ring closure. Thus, a porous polyimide layer having a film layer was obtained. This porous layer was a uniform spongy layer. The copper foil-clad layered polyimide product obtained had a film layer thickness of 20 µm, porous layer thickness of 5 µm, porosity of 9%, and permittivity of 3.2.

The results obtained in Examples 1 to 3 and Comparative Examples 1 to 6 are shown in Tables 1 and 2 below. The "Ethanol infiltration" in the Tables shows the results of a test in which the copper foil was removed by etching from the layered polyimide product obtained and ethanol was dropped onto the thus-exposed surface of the layered polyimide product to examine the surface for ethanol infiltration. The samples into which ethanol did not infiltrate are indicated by ○ and those into which ethanol infiltrated are indicated by ×.

TABLE 1

|  | Example 1 | Example 2 | Example 3 | Comparative Example 6 |
|---|---|---|---|---|
| Total thickness | 25 µm | 25 µm | 25 µm | 25 µm |
| Thickness of film layer | 3 µm | 5 µm | 10 µm | 20 µm |
| Porosity | 40% | 36% | 27% | 9% |
| Permittivity ε' | 2.4 | 2.5 | 2.8 | 3.2 |
| Ethanol infiltration | ○ | ○ | ○ | ○ |

TABLE 2

|  | Comparative Example 1 | Comparative Example 2 | Comparative Example 3 | Comparative Example 4 | Comparative Example 5 |
|---|---|---|---|---|---|
| Total thickness | 26 µm | 30 µm | 33 µm | 34 µm | 25 µm |
| Thickness of film layer | Unclear boundary | Unclear boundary | Unclear boundary | Unclear boundary | None |
| Porosity | 45% | 44% | 42% | 33% | 45% |
| Permittivity ε' | 2.2 | 2.2 | 2.3 | 2.6 | 2.2 |
| Ethanol infiltration | × | × | × | ○ | × |

The results shown in Tables 1 and 2 above show the following. The metal foil-based layered products obtained in the Examples not only were free from ethanol infiltration to have sufficient barrier properties, but showed the sufficient effect of reducing the permittivity of the whole insulating layer. In contrast, the metal foil-based layered products of Comparative Examples 1 to 3, in which the undercoat film layer had not been imidized before film formation thereon, and the metal foil-based layered product of Comparative Example 5, in which no undercoat film layer had been formed, showed insufficient barrier properties because the undercoat film layer had been incapable of retaining its shape or because of the absence of an undercoat film layer. The metal foil-based layered product of Comparative Example 4, in which an undercoat film layer had been formed thickly and had not been imidized before film formation thereon, had problems, for example, that it was difficult to regulate the thickness of the resin film layer because the undercoat film layer had become porous, although it had barrier properties. Furthermore, the metal foil-based layered product of Comparative Example 6, in which the undercoat film layer had been too thick, had a considerably increased permittivity.

**Claims**

1.  A metal foil-based layered product comprising a metal foil and a porous resin layer formed on the metal foil through a resin film layer, the resin film layer having a thickness of from 0.1 to 15 µm, and
    wherein the resin film layer and the porous resin layer each comprise a polyimide resin.

2.  The metal foil-based layered product as claimed in claim 1, wherein the resin film layer does not substantially penetrate into pores of the porous resin layer.

3.  A process for producing a metal foil-based layered product which comprises the steps of: forming on a metal foil an undercoat film layer comprising a poly(amic acid) which has been imidized at least partly; forming a porous precursor layer on the undercoat film layer by a wet film-forming method using a solution containing a poly(amic acid); and imidizing at least the porous precursor layer.

4.  The process as claimed in claim 3, wherein the step of forming the undercoat film layer comprises applying a solution containing a poly(amic acid) to the metal foil and then subjecting the resulting coating to drying and imidization.

5.  The process as claimed in claim 3, wherein the undercoat film layer has a thickness of from 0.1 to 15 µm.

**Patentansprüche**

1.  Ein Metallfolie-basierendes, geschichtetes Produkt, das eine Metallfolie und eine poröse Harzschicht umfasst, die auf der Metallfolie durch eine Harzfilmschicht gebildet wird, wobei die Harzfilmschicht eine Dicke von 0,1 - 15 µm aufweist, und worin die Harzfilmschicht und die poröse Harzschicht jeweils einen Polyimidharz umfassen.

2.  Das Metallfolie-basierende, geschichtete Produkt, wie es in Anspruch 1 beansprucht wird, worin die Harzfilmschicht nicht wesentlich in die Poren der porösen Harzschicht eindringt.

3.  Ein Verfahren zur Herstellung eines Metallfolie-basierenden, geschichteten Produkts, das die folgenden Schritte umfasst: die Herstellung einer Grundierfilmschicht auf einer Metallfolie, umfassend eine Poly(amidsäure), die wenigstens teilweise imidiert wurde; die Bildung einer porösen Vorläuferschicht auf der Grundierfilmschicht durch ein nasses Film-bildendes Verfahren unter Verwendung einer Lösung, die eine Poly(amidsäure) enthält; und die Imidierung wenigstens der porösen Vorläuferschicht.

4.  Das Verfahren, wie es in Anspruch 3 beansprucht wird, worin der Schritt der Bildung der Grundierfilmschicht das Auftragen einer Lösung umfasst, die eine Poly(amidsäure) enthält, auf die Metallfolie und dann das Trocknen und Imidieren der resultierenden Beschichtung.

5.  Das Verfahren, wie es in Anspruch 3 beansprucht wird, worin die Grundierfilmschicht eine Dicke von 0,1-15 µm aufweist.

**Revendications**

1.  Produit stratifié à base de feuille métallique, comprenant une feuille métallique et une couche de résine poreuse formée sur la feuille métallique à travers une couche de film de résine, la couche de film de résine ayant une épaisseur de 0,1 à 15 µm, et
    dans lequel la couche de film de résine et la couche de résine poreuse comprennent chacune une résine polyimide.

2.  Produit stratifié à base de feuille métallique selon la revendication 1, dans lequel la couche de film de résine ne pénètre sensiblement pas dans les pores de la couche de résine poreuse.

**3.** Procédé de production d'un produit stratifié à base de feuille métallique, qui comprend les étapes de : formation, sur une feuille métallique, d'une sous-couche de film comprenant un poly(amique acide) qui a été imidé au moins partiellement ; formation d'une couche de précurseur poreuse sur la sous-couche de film par un procédé de formage de film humide en utilisant une solution contenant un poly(amique acide) ; et imidation d'au moins la couche de précurseur poreuse.

**4.** Procédé selon la revendication 3, dans lequel l'étape de formation d'une sous-couche de film comprend l'application d'une solution contenant un poly(amique acide) sur la feuille métallique et puis la soumission du revêtement résultant au séchage et à l'imidation.

**5.** Procédé selon la revendication 3, dans lequel la sous-couche de film possède une épaisseur de 0,1 à 15 μm.